# FASCICULE DE BREVET EUROPEEN

(11) **EP 1 943 725 B1**
(45) Date de publication et mention de la délivrance du brevet: **04.11.2009**
(21) Numéro de dépôt: 06820304.1
(22) Date de dépôt: 17.10.2006
(51) Int. Cl.: H02P 9/48, G01R 19/00

(54) **MESURE D'UN COURANT DELIVRE PAR UNE MACHINE ELECTRIQUE TOURNANTE TELLE QU'UN ALTERNATEUR**
MESSUNG EINES VON EINER ELEKTRISCHEN DREHMASCHINE WIE EIN GENERATOR GELIEFERTEN STROMS
MEASURING A CURRENT SUPPLIED BY A ROTATING ELECTRIC MACHINE SUCH AS AN ALTERNATOR

(30) Priorité: 04.11.2005 FR 0511229
(43) Date de publication de la demande: 16.07.2008
(73) Titulaire: VALEO EQUIPEMENTS ELECTRIQUES MOTEUR, 94046 Créteil (FR)
(72) Inventeur: PIERRET, Jean-Marie, F-75012 Paris (FR); RECHDAN, Raymond, F-94410 Saint Maurice (FR)
(74) Mandataire: Tran, Chi-Hai
(86) Numéro de dépôt international: PCT/FR2006/051045
(87) Numéro de publication internationale: WO 2007/051936

(56) Documents cités:
- DE-A- 10 112 217
- DE-A- 19 548 362
- JP-A- 7 191 106
- US-A- 4 937 528
- US-A1- 2004 155 546
- US-B1- 6 618 228

## Description

### Domaine technique de l'invention

La présente invention concerne la mesure d'un courant délivré par une machine électrique tournante, notamment un alternateur ou un alterno-démarreur, notamment pour la gestion du fonctionnement d'un moteur de véhicule automobile.

L'invention s'applique à tous types de véhicules nécessitant, par exemple, une gestion moteur en tenant compte du couple résistif imposé par l'alternateur au moteur, lors de besoin en énergie électrique supplémentaire.

### Etat de la technique

Une machine électrique tournante, en particulier un alternateur, comporte de façon conventionnelle:
- un stator,
- un rotor.

Un alternateur est couplé à un vilebrequin d'un moteur d'un véhicule automobile par l'intermédiaire de moyens de transmission de puissance comme une courroie de transmission. L'alternateur est ainsi entraîné par le moteur pour produire de l'énergie électrique afin d'alimenter une ou des batteries et les divers équipements électriques. La ou les batteries ainsi que les équipements électriques sont appelés ci-après charges électriques.
Si ces charges sont mises en service, le courant débité par l'alternateur doit être augmenté en réponse à leur besoin.
L'alternateur va alors imposer au moteur thermique un couple résistif supplémentaire susceptible de faire caler le moteur, dans certains cas, si un moyen de contrôle du moteur n'enrichit pas en carburant le mélange d'alimentation du moteur afin de maintenir un régime suffisant. De manière générale, un tel moyen de contrôle permet de mieux gérer le fonctionnement du moteur.
Pour améliorer la gestion du moteur, il convient de choisir de façon optimisée les paramètres d'entrées du moyen de contrôle afin de donner une

image fidèle de l'état de fonctionnement de l'alternateur.

Dans le document WO 02/071570, le paramètre reçu par le moyen de contrôle du moteur est un signal représentatif du courant circulant dans le bobinage d'excitation d'un rotor d'un alternateur. Pour cela le document propose un dispositif qui comprend trois parties principales, à savoir un circuit de mesure du courant circulant dans le bobinage du rotor, un circuit de mémorisation de la valeur mesurée et un circuit apte à délivrer un signal représentatif du niveau du courant d'excitation.
Ce signal est ensuite traité par un système extérieur à l'alternateur, par exemple un moyen de contrôle du moteur, pour en déduire le courant débité et le couple résistif de l'alternateur. Cependant, le moyen de contrôle d'un véhicule qui exploite cette information doit avoir en mémoire les caractéristiques (sous la forme de valeurs préenregistrées) de tous les alternateurs qui peuvent être montés sur ce véhicule, ce qui mobilise une taille mémoire importante dans le moyen de contrôle et reste une gestion lourde pour les constructeurs automobiles.
Ces constructeurs souhaitent aujourd'hui que le moyen de contrôle reçoive non plus un signal représentatif du courant d'excitation mais directement la valeur du courant débité par l'alternateur. Or la détermination du courant débité par l'alternateur, réalisée sur la base du courant circulant dans le bobinage d'excitation, nécessite une taille mémoire importante pour le traitement du courant, incompatible avec la taille mémoire limitée des microcontrôleurs habituellement incorporés, par exemple, dans les régulateurs de tension conventionnels. Cette détermination est en effet habituellement réalisée à partir d'une table complexe. Cette table doit mémoriser le courant débité par l'alternateur en fonction de sa vitesse de rotation, du courant d'excitation, de la température et de la tension batterie mesurée par le régulateur.
On connaît un document US-A-4 937 528 qui décrit un appareil pour déterminer la capacité d'une batterie d'un véhicule, et notamment l'état de charge de cette batterie. Cet appareil est placé entre la batterie et une autre source de tension pouvant être un alternateur.
On connaît aussi un document DE 101 12 217 A qui décrit un dispositif mesurant une chute de tension dans une portion de circuit électronique comprise entre une phase d'un alternateur et la masse, avec prise en compte d'une résistance de ligne.

### Exposé de l'invention

Aussi, un problème technique à résoudre par l'objet de la présente invention est de proposer un dispositif pour la mesure d'un courant d'un alternateur, et un procédé de commande de ce dispositif de mesure qui permettent :
- de déterminer le courant débité par l'alternateur en limitant les opérations de traitement et l'utilisation de la mémoire dans les microcontrôleurs,
- de réaliser cette détermination de manière simple et économique;
- de transmettre l'information du courant débité par la machine vers un système extérieur à l'alternateur.

A cet effet, l'invention a pour objet une machine électrique tournante comprenant un dispositif pour la mesure d'un courant tel qu'énoncé à la revendication 1.

Une solution au problème technique posé est selon un premier objet de la présente invention que le courant mesuré est un courant circulant entre le stator et les charges électriques.
Grâce à l'invention, on obtient facilement une information sur la valeur du courant débité par l'alternateur. En outre, on s'affranchit d'un certain nombre de paramètres tel que par exemple la température.

Un deuxième objet de l'invention, concerne un procédé de commande du dispositif pour la mesure d'un courant dans lequel un moyen interrupteur, encore appelé interrupteur, est commandé dans une première position durant un écart de temps pendant lequel on vient mesurer le courant et en ce que le moyen interrupteur est commandé dans une deuxième position en dehors de l'écart de temps.
La commande du moyen interrupteur permet ainsi de limiter le temps durant lequel la résistance est parcourue par un courant ce qui limite la dissipation thermique. En outre, la résistance variant peu en fonction de la température, la chute de tension mesurée est fiable quelque soit le fonctionnement de la machine électrique tournante.

L'invention a également pour objet une machine électrique tournante, notamment un alternateur ou un alterno-démarreur, capable d'alimenter des charges électriques, comportant :
- un stator,
- un rotor,
- un dispositif pour la mesure d'un courant présent dans la machine électrique tournante alimentant les charges électriques,
**caractérisée en ce que** le dispositif est placé entre la sortie du stator et les charges électriques de manière à mesurer un courant circulant entre le stator et les charges électriques.

L'invention a encore pour objet une machine électrique tournante, notamment un alternateur ou un alterno-démarreur, capable d'alimenter des charges électriques, comportant :
- un stator,
- un rotor,
- un dispositif pour la mesure d'un courant présent dans la machine électrique tournante alimentant les charges électriques,
**caractérisée en ce que** ce dispositif comprend une résistance et en ce que ledit dispositif est agencé pour mesurer une chute de tension sur au moins une borne de ladite résistance.

L'invention a également pour objet une machine électrique tournante, notamment un alternateur ou un alterno-démarreur, capable d'alimenter des charges électriques, comportant:
- un stator,
- un rotor,
- un dispositif pour la mesure d'un courant présent dans la machine électrique tournante alimentant les charges électriques,
**caractérisée en ce que** ce dispositif comprend une sonde à effet Hall et en ce que ledit dispositif est agencé pour mesurer le courant à l'aide de ladite sonde à effet Hall.

D'autres particularités, avantages ou résultats de l'invention ressortiront de la description suivante donnée à titre d'exemple et illustrée par les figures annexées.

### Brève description des figures

La Fig. 1 est un schéma électrique de l'invention selon un premier mode de réalisation,
La Fig. 2 est un schéma électrique de l'invention selon un deuxième mode de réalisation,
La Fig. 3 est un schéma électrique de l'invention selon un troisième mode de réalisation,
La Fig. 4 est un schéma électrique de l'invention selon un quatrième mode de réalisation,
La Fig. 5 est une représentation graphique pour la commande du dispositif de mesure d'un courant selon un premier procédé,
La Fig. 6 est une représentation graphique pour la commande du dispositif de mesure d'un courant selon un deuxième procédé,
La Fig. 7 est une représentation graphique pour la commande du dispositif de mesure d'un courant selon un troisième procédé.

### Description détaillée de modes de réalisation de l'invention.

Dans la description qui suit, on a représenté un exemple de machine électrique tournante, tel qu'un alternateur pour un véhicule automobile.

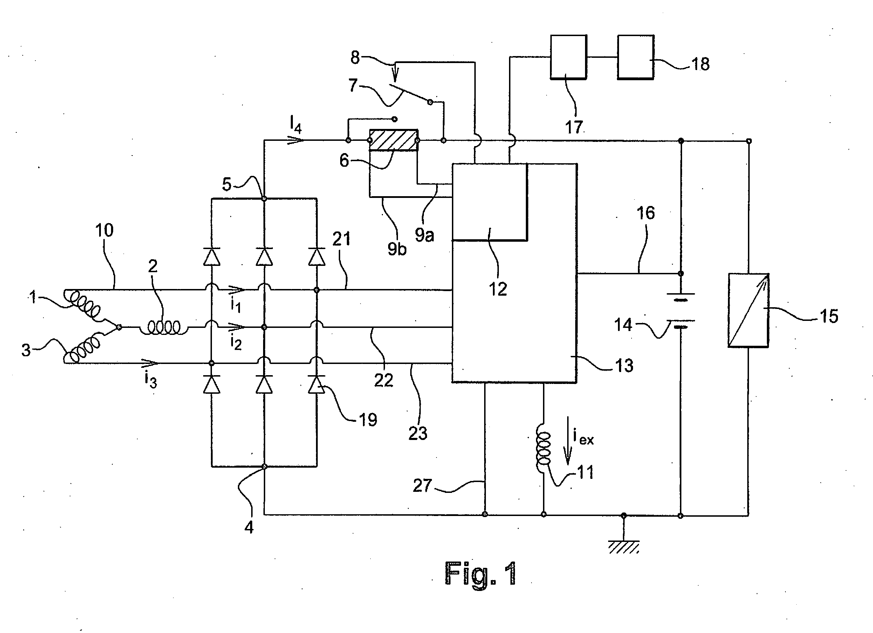

On a représenté à la Fig. 1, un alternateur comprenant un stator 10 ou induit.
Le stator est ici représenté avec trois bobinages décalés de 120° formant les trois phases 1, 2, 3 du stator, en variante le nombre de phases peut être inférieur ou supérieur à trois.
Les phases du stator, en fonction des applications, sont raccordées soit en étoile ou en triangle.

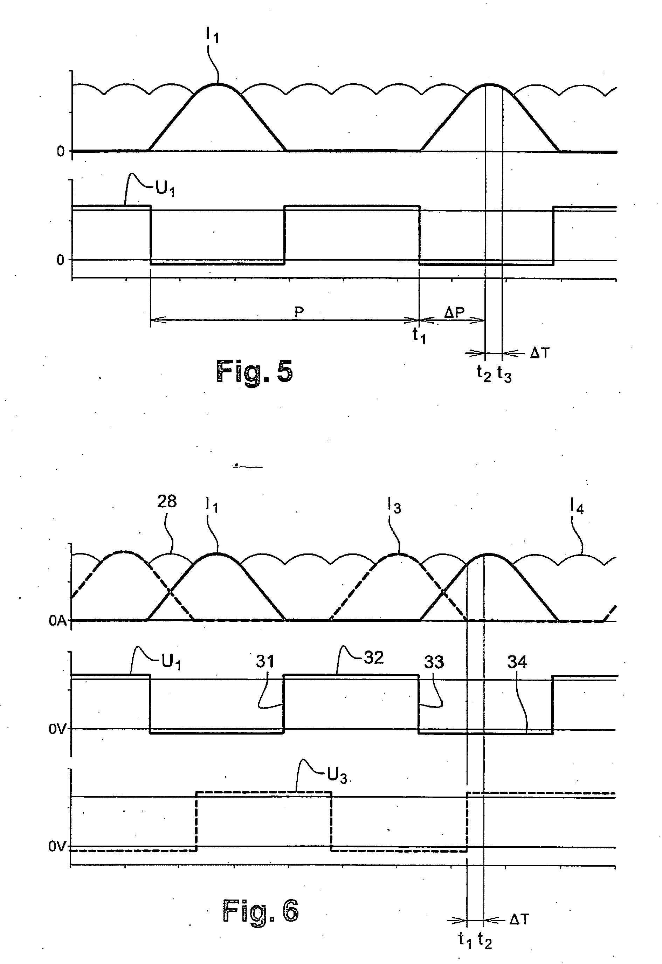

Le rotor est mis en rotation par un moteur 18 de véhicule par l'intermédiaire de moyens de transmission de puissance entre le rotor et le moteur comme par exemple une courroie de transmission.
Le rotor 11 ou inducteur crée un champ magnétique tournant générant un courant alternatif I1, I2, I3 sur chacune des phases du stator.
Chaque courant alternatif comporte des alternances positives et négatives.
Chaque phase du stator est connectée à une paire d'éléments électroniques 19. Ces éléments peuvent être par exemple des diodes, des diodes Zener, ou des transistors. Dans le cas où ces éléments interrupteurs sont des diodes, chaque phase est connectée à l'anode d'une diode dite diode positive et à la cathode de l'autre diode dite diode négative, ces deux diodes formant la paire d'éléments électroniques pour la phase considérée.
La cathode des diodes positives est reliée à la tension du réseau du véhicule, et l'anode des diodes négatives à la masse du système.
Ces diodes positives et négatives forment un moyen redresseur, encore appelé redresseur, de courant ou pont redresseur comportant une ou plusieurs branches.
Comme visible par exemple sur les Fig. 5, 6, 7, les tensions U1, U2, U3 présentes sur les phases 1, 2, 3 sont déformées et prennent l'allure d'un signal carré ayant des niveaux bas 34 et des niveaux hauts 32 séparés par des fronts montants 31 et des fronts descendants 33.
Les niveaux hauts sont, par exemple, à une tension égale à la tension de la batterie Vbat auquel on additionne la tension de jonction d'un élément électronique 19 du moyen redresseur. L'élément électronique est par exemple une diode et la tension de jonction est par exemple égale à 0,8 volt.
Les niveaux bas sont, par exemple, à une tension égale à la tension masse auquel on retranche la tension de jonction d'un élément électronique 19 du moyen redresseur.
Les courants I1, I2, I3 en sortie des phases sont lissés par les inductances de l'induit de l'alternateur et gardent une allure sensiblement sinusoïdale. Ces courants en sortie des phases se retrouvent dans chacune des demi-branches du moyen redresseur en fonction de l'état passant ou non passant des éléments électroniques 19.

Le redressement des courants I1, I2, I3 par le moyen redresseur constitue le courant l4 délivré par l'alternateur.
Le courant I4 comprend une forte composante continue affectée d'une composante alternative de faible amplitude. La composante alternative se présente sous la forme de calottes 28 sinusoïdales. Les calottes sont constituées par les sommets des courants I1, I2, I3 sensiblement sinusoïdaux présents en sortie des phases.
Ce courant 14 va venir alimenter les charges électriques, c'est-à-dire la ou les batteries 14 ainsi que les équipement électriques 15.
On notera que les diodes du moyen redresseur évitent également que la ou les batteries ne se déchargent dans les enroulements du stator.

La tension de l'alternateur en sortie 5 du moyen redresseur augmente avec la vitesse de rotation du rotor et donc du moteur. Cependant la batterie 14 ne peut recevoir plus d'une certaine tension sous peine de destruction par échauffement de l'électrolyte.
Un régulateur 13 va alors maintenir constante la tension présente sur le réseau de bord du véhicule dans toutes les plages de rotation du moteur.
Pour cela, le régulateur 13 va régler le courant d'excitation lex traversant le rotor 11 en fonction d'une tension mesurée soit aux bornes du moyen redresseur soit aux bornes de la batterie par l'intermédiaire d'un élément filaire 16. Le choix de la tension mesurée peut se faire selon l'état du régulateur (mode de fonctionnement normal ou mode dégradé).
Si la tension présente sur le réseau de bord est inférieure à une tension de régulation de référence, par exemple quatorze volts, le régulateur maintient un courant d'excitation lex élevé.
Lorsque la tension présente sur le réseau de bord dépasse la tension de régulation de référence, le régulateur 13 va couper le courant d'excitation lex pour diminuer cette tension du réseau de bord.
Si la tension devient inférieure a la tension de régulation, le courant d'excitation augmente de nouveau. Puis le cycle recommence.

Pour pouvoir effectuer la régulation de manière appropriée, le régulateur est relié, via un élément filaire 27, à la masse.

Le couple résistif de l'alternateur est dépendant du courant débité par l'alternateur, de la tension fournie par celui-ci, de la vitesse de rotation du rotor et du rendement de l'alternateur. Afin de simplifier les calculs mis en oeuvre, on ne considère que des paramètres continus équivalents. Ainsi, on utilisera par exemple la valeur moyenne du courant redressé l4 pour le calcul du couple résistif.
Cette valeur moyenne sera transmise au moyen de contrôle moteur 17 pour le calcul de ce couple résistif. En variante, le couple résistif peut être calculé par le régulateur lui-même, car celui-ci dispose de tous les paramètres et de toutes les caractéristiques de l'alternateur.

Ainsi, un dispositif pour la mesure d'un courant présent dans l'alternateur va mesurer un courant circulant entre le stator de l'alternateur et des charges constituées par exemple par une ou plusieurs batteries 14 et des équipements électriques 15 branchés sur le réseau de bord.
Un premier mode de réalisation est décrit et représenté à la Fig. 1, dans lequel le dispositif mesure le courant 14 en sortie 5 du moyen redresseur, le moyen redresseur étant connecté en sortie du stator 10.
Les moyens de mesure comprennent une résistance 6 qui est placée en série avec la sortie 5 du moyen redresseur. Un dispositif de traitement 12 vient mesurer la tension aux bornes de la résistance 6 image du courant y passant, via deux éléments filaires 9a, 9b. Pour cela le dispositif de traitement est activé, par exemple, lorsqu'on veut effectuer cette mesure.
Le dispositif de traitement 12 va alors par exemple amplifier la tension mesurée, et la traiter pour la rendre exploitable. Cette tension est ensuite codée soit dans un vrai protocole ou bien sous forme de rapport cyclique et envoyée ensuite à un moyen de contrôle 17 agissant sur un moteur 18 du véhicule. Le moteur en réaction va accélérer ou ralentir ce qui va influencer la rotation du rotor 11.
L'utilisation d'une résistance permet de rendre la mesure simple et économique. En outre, la résistance variant peu en fonction de la température, la chute de tension mesurée est fiable.

Pour éviter une trop grande dissipation d'énergie due au passage d'un courant de forte valeur (jusqu'à 200 Ampères), il est prévu que les moyens de mesure comprennent, en parallèle de la résistance 6, un moyen interrupteur 7 dont l'ouverture est commandée par un moyen 8 relié au dispositif de traitement 12.
Le moyen interrupteur 7 peut être, par exemple, un transistor.
Lorsque le moyen interrupteur 7 est ouvert, le courant I4 traverse la résistance 6 et le dispositif de traitement va mesurer la chute de tension aux bornes de cette résistance.
La chute de tension est due au passage du courant I4 dans la résistance 6. Le dispositif de traitement 12 va en fonction de cette chute de tension en déduire la valeur moyenne du courant I4.
En outre, lorsque le moyen interrupteur 7 est fermé, le courant I4 va le traverser, court-circuitant la résistance. En effet, le moyen interrupteur est moins résistif que la résistance de l'élément 6. Aucune mesure n'est alors réalisée par le dispositif de traitement 12.

Le moyen interrupteur 7 est commandé dans sa première position durant un écart de temps ΔT pendant lequel on vient mesurer le courant et il est commandé dans une deuxième position en dehors de cet écart de temps ΔT.

Le moyen interrupteur 7 peut être commandé dans sa première et sa deuxième position en fonction de la tension présente sur au moins une phase. Ceci permet d'adapter la mesure en fonction de la période P de la tension présente sur au moins une phase.

En variante, la résistance 6 peut être remplacée par une sonde à effet Hall. La sonde délivre à sa sortie une tension proportionnelle à l'intensité du courant qui la traverse. Cette sonde dissipe peu d'énergie. En conséquence, elle peut mesurer en permanence le courant I4 présent en sortie du moyen redresseur de l'alternateur. II n'y a donc pas d'interrupteur 7 mais c'est le dispositif de traitement, lors de son activation, qui détermine l'instant de mesure. Cette activation du dispositif de traitement peut se faire en fonction de la tension présente sur au moins une phase.

La mesure peut être par exemple un échantillon de mesures dont on déterminera la valeur moyenne à laquelle on appliquera un coefficient de correction déterminé afin de définir la valeur moyenne du courant redressé I4.
En variante, la correction peut se faire sur chaque mesure de l'échantillon. D'autres méthodes de détermination de la valeur moyenne d'un courant redressé existent, et la présente description n'est pas limitée aux exemples décrits ci-dessus.

Comme l'instant de mesure est déterminé en fonction de la connaissance d'au moins une tension présente sur au moins une phase, les mesures s'effectuent dans une partie identique des calottes des courants, ce qui permet un traitement plus simple pour obtenir la valeur moyenne du courant I4 redressé.

En variante, on peut venir mesurer le courant en sortie d'une phase 1, 2, 3, par exemple dans une demi-branche du moyen redresseur. On réduit ainsi les dimensions des capteurs.
En effet dans les demi-branches du moyen redresseur, les sections des conducteurs sont plus faibles car elles ne sont parcourues que par un courant dont la valeur moyenne est le tiers de la valeur moyenne du courant redressé I4.

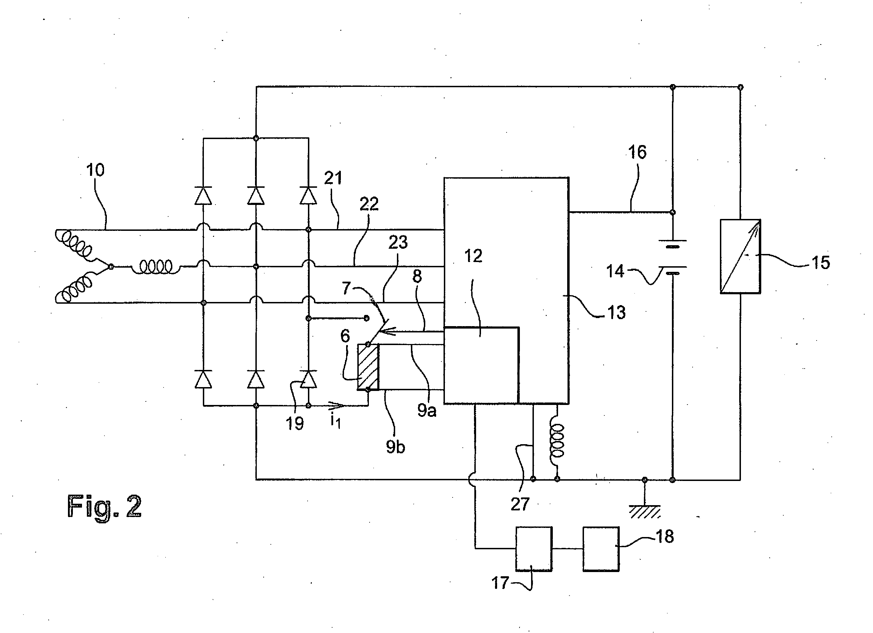

Ainsi, dans un second mode de réalisation représenté à la Fig. 2, on vient mesurer le courant traversant une demi-branche du moyen redresseur.
Une résistance 6 et un moyen interrupteur 7 sont placés en parallèle aux bornes d'un élément électronique 19 par exemple une diode.
Le moyen interrupteur 7 est commandé par le dispositif de traitement 12 via l'élément de commande 8. Lorsque le moyen interrupteur 7 est ouvert le courant I1 traverse la diode. Lorsque l'interrupteur est fermé le courant I1 est dérivé dans la résistance 6, la chute de tension est alors mesurée par le dispositif de traitement 12 via des éléments filaires 9a, 9b, 27. Les éléments filaires 9a, 9b sont connectés aux bornes de la résistance 6. L'élément filaire 27 connecte le régulateur à la masse. Ces éléments filaires déterminent la portion de circuit dans laquelle s'effectue la détermination de la chute de tension. On peut réaliser ainsi la mesure du courant sur au moins une borne de la résistance 6.
Si on détermine la chute de tension dans la portion de circuit comprise entre les élément filaires 9a et 27, il faudra alors tenir compte, dans la mesure du courant, d'une résistance de ligne inhérente au moyen de redressement.
Si on détermine la chute de tension dans la portion de circuit comprise entre les éléments filaires 9a et 9b, c'est-à-dire directement aux bornes de la résistance 6, on ne tient alors pas compte, dans la mesure du courant, de la résistance de ligne du moyen redresseur.

La résistance 6 et le moyen interrupteur 7 doivent être adaptés de manière que la chute de tension dans ces deux éléments soit inférieure à la tension de jonction de la diode 19. Ainsi, lorsque le moyen interrupteur 7 se ferme, le courant I1 est dérivé dans la résistance 6.
Le moyen interrupteur 7 est fermé pendant un écart de temps ΔT court pour éviter une trop grande dissipation d'énergie dans la résistance et pour ne pas déborder la phase de conduction de la diode 19.

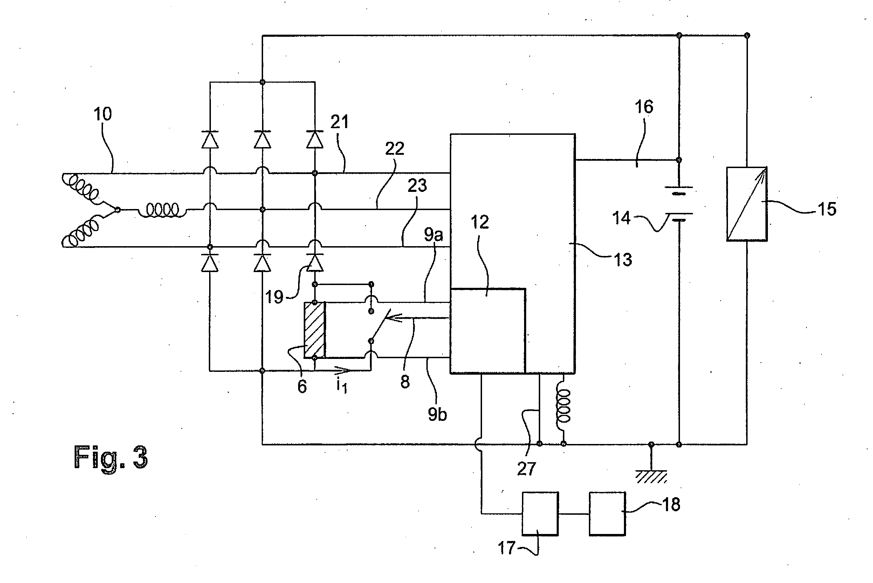

Dans un autre mode de réalisation présenté à la Fig. 3, on a placé la résistance 6 en série avec la diode 19. Un moyen interrupteur 7 est en parallèle aux bornes de la résistance 6.
Lors du fonctionnement normal du moyen redresseur, le moyen interrupteur 7 est fermé. Pour effectuer la mesure du courant, le moyen interrupteur 7 s'ouvre, le courant I1 est alors dérivé dans la résistance 6 et une information de tension est disponible pour le dispositif de traitement 12 via les éléments filaires 9a, 9b, 27.
Contrairement au mode de réalisation précédent, il n'est pas nécessaire de choisir la valeur de la résistance 6 en fonction de la diode 19.
On peut choisir ainsi une résistance de valeur plus élevée, la chute de tension mesurée est alors plus grande ce qui permet d'utiliser un amplificateur moins précis que dans le mode de réalisation de la Fig.2 pour effectuer le traitement.

Pendant le passage du courant dans la résistance, le dispositif de traitement est activé pour réaliser la mesure et le traitement de celle-ci. La commande de ce dispositif de traitement peut se faire comme pour la commande de l'interrupteur 7, c'est-à-dire par l'analyse d'au moins une tension présente sur une phase 1, 2, 3.

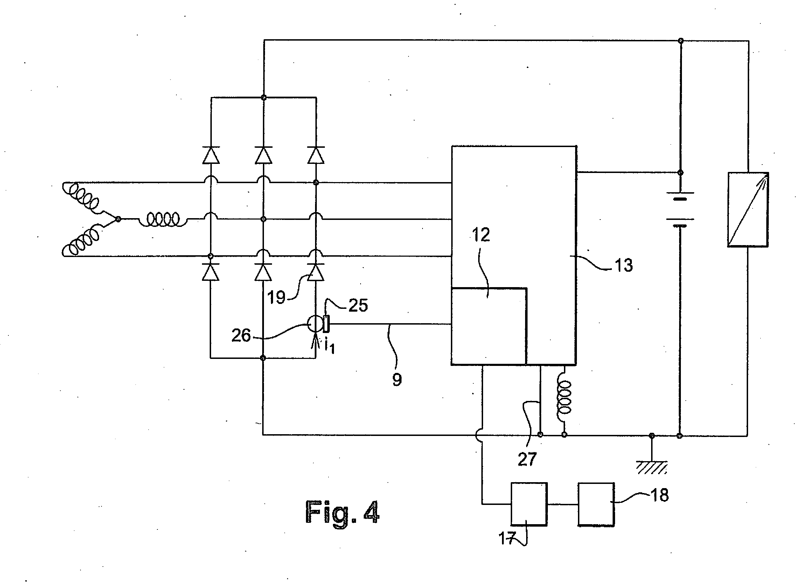

En variante, comme visible à la Fig. 4, on peut utiliser une sonde à effet Hall.
La sonde à effet Hall 25 est, par exemple, montée dans l'entrefer d'un circuit magnétique annulaire 26.
Comme la sonde à effet Hall dissipe peu d'énergie, elle peut mesurer en permanence le courant qui traverse la demi-branche du moyen redresseur. II faut, cependant, que le dispositif de traitement soit activé pour réaliser la mesure et le traitement du courant traversant la sonde. La commande de ce dispositif de traitement peut se faire par l'analyse d'au moins une tension présente sur une phase 1, 2, 3.

La mesure est ensuite corrigée par le dispositif de traitement afin de déterminer la valeur moyenne du courant redressé I4.

Dans les exemples présentés ci-dessus, le dispositif de traitement 12 est intégré au régulateur 13. Ceci permet de diminuer l'encombrement de l'ensemble.

En variante le dispositif de traitement 12 peut être dissocié du régulateur.

La détermination de la chute de tension est réalisée dans une portion de circuit qui ne comprend pas d'élément électronique 19 tel qu'une diode ce qui facilite la mesure du courant. En effet, dans une diode, la résistance varie en fonction de la température, ce qui oblige à corriger la valeur de la chute de tension en fonction de cette température. De plus, la diode est soumise à des phénomènes de dispersion due à sa fabrication ce qui peut entraîner une variabilité des mesures.

On a représenté sur les Fig. 2, 3 un moyen interrupteur 7 présent sur la demi-branche négative du moyen redresseur entre la phase et la masse. Ceci permet, dans le cas où le moyen interrupteur est un transistor, une commande entre 0 et 10 volts.
En variante la détermination de la chute de tension peut se faire sur la demi-branche positive entre la tension de la batterie et la phase. La commande du moyen interrupteur 7 doit être alors adaptée.

Dans tous les cas, il est nécessaire de déterminer la commande du moyen interrupteur pour que les mesures successives s'effectuent dans la même portion des calottes de courant.

Le moyen interrupteur est commandé dans une première position durant un écart de temps ΔT pendant lequel on vient mesurer le courant et le moyen interrupteur 7 est commandé dans une deuxième position en dehors de l'écart de temps ΔT

Comme visible à la Fig. 5, un premier procédé de commande consiste à commander le moyen interrupteur en fonction de la tension présente sur la phase en sortie de laquelle est mesuré le courant.
La tension phase est, par exemple, transmise au régulateur 13 via un élément filaire 21, 22, 23.
Le procédé comporte les étapes ci-après.
Le régulateur mesure la tension présente sur la phase en sortie de laquelle est mesuré le courant.
Le régulateur mesure une période P de la tension présente sur cette première phase.
Le régulateur détecte un intervalle de temps ΔP proportionnel à la période P. L'intervalle de temps peut, par exemple, être égal à la période P divisée par quatre.
Le régulateur détecte, en outre, un premier temps t1 où la tension présente sur la première phase est dans un front descendant.
Le moyen interrupteur 7 est amené dans une première position, dans laquelle on vient mesurer le courant de la première phase, à partir d'un deuxième temps t2 égal au premier temps t1 additionné de l'intervalle de temps ΔP.
Le moyen interrupteur 7 est amené dans une deuxième position, dans laquelle on ne vient pas mesurer le courant de la première phase, à partir d'un troisième temps t3 égal au deuxième temps t2 additionné d'un écart de temps ΔT.

Comme visible à la Fig. 6, un second procédé consiste à commander l'interrupteur en fonction de la tension présente sur au moins une phase autre que la phase en sortie de laquelle est mesuré le courant.
Dans le cas où le stator comporte trois phases, le procédé comporte les étapes ci-après.
Le régulateur mesure la tension U3 de la troisième phase 3.
Le régulateur 13 détecte un premier temps t1 où la tension de la troisième phase est dans un front montant,
Le moyen interrupteur 7 est ainsi amené dans sa première position, dans laquelle on vient mesurer le courant présent sur la première phase, à partir du premier temps t1.
Le moyen interrupteur 7 est amené dans sa deuxième position, dans laquelle on ne vient pas mesurer le courant, à partir d'un deuxième temps t2 égal au premier temps t1 additionné d'un écart de temps ΔT.

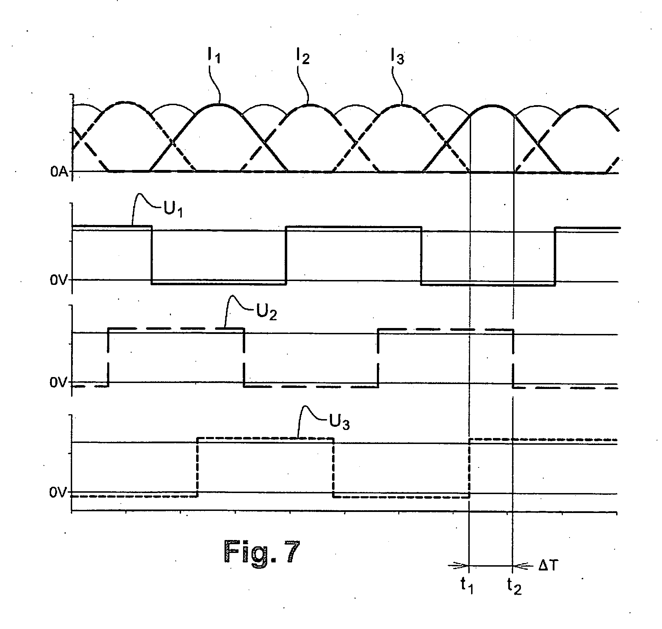

Comme visible à la Fig. 7, un troisième procédé consiste à utiliser les informations de tension d'une deuxième phase et d'une troisième phase du stator pour effectuer la mesure sur le courant présent en sortie de la première phase.
A cet effet, le régulateur mesure la tension U2 de la deuxième phase 2.
Le régulateur mesure la tension U3 de la troisième phase 3.
Le régulateur détecte un premier temps t1 où la tension U3 de la troisième phase est confondue avec la tension U2 de la deuxième phase 2 sur son niveau haut.
Le moyen interrupteur 7 est alors amené dans sa première position, dans laquelle on vient mesurer le courant de la première phase, à partir du premier instant t1.
Le moyen interrupteur 7 est amené dans sa deuxième position, dans laquelle on ne vient pas mesurer le courant de la première phase, à partir d'un deuxième instant t2. Le deuxième temps t2 est par exemple détecté lorsque la tension U2 de la deuxième phase 2 n'est plus confondue avec la tension U3 de la troisième phase 3 sur son niveau haut.
L'écart de temps ΔT, entre les temps t1 et t2, correspond à l'écart entre le front montant de la phase 3 et le front descendant de la phase 2. Cet écart correspond sensiblement à la durée d'une calotte de redressement. II est donc possible de déterminer plus facilement la valeur moyenne du courant redressé. Ceci permet de rendre la mesure plus précise.

Dans les différents procédés, l'écart de temps ΔT est inférieur à la période P divisée par deux d'une tension présente sur une phase. Avantageusement, l'écart de temps ΔT est inférieur à une période divisée par six. L'écart de temps ΔT, est par exemple de l'ordre de quelques dizaines de microsecondes.
On notera que les tensions présentes sur les différentes phases ont la même période P.

L'invention permet ainsi par la mesure d'un courant circulant entre le stator et les charges électriques 14, 15 de déterminer le couple résistant de l'alternateur en temps réel au cours du fonctionnement de la machine électrique tournante.

La présente description n'est pas limitée aux exemples de réalisation décrits ci-dessus, en particulier elle a été décrite dans le cadre d'un alternateur mais est applicable à une machine électrique tournante, telle qu'un alterno-démarreur ou un ralentisseur électromagnétique.

Le stator, le rotor et le dispositif de mesure sont placés dans une enceinte commune.

En variante, le dispositif de mesure est placé dans un boîtier distinct de l'enceinte dans laquelle sont disposés le stator et le rotor, le boîtier étant notamment relié à cette enceinte par une liaison électrique.

## Revendications

1. Machine électrique tournante, notamment un alternateur ou un alterno-démarreur, capable d'alimenter des charges électriques, comportant :
- un stator (10),
- un rotor (11),
- un redresseur de courant connecté en sortie du stator,
- un dispositif pour la mesure d'un courant présent dans la machine électrique tournante alimentant les charges électriques (14, 15),
**caractérisée en ce que** le stator (10) comporte une ou plusieurs phases et **en ce que** le dispositif est placé dans une demi-branche du redresseur de manière à mesurer un courant (I1, I2, 13) en sortie d'une phase (1, 2, 3), circulant entre le stator et les charges électriques (14,15).

2. Machine selon la revendication précédente **caractérisée en ce que** le dispositif comprend une résistance (6).

3. Machine selon la revendication précédente **caractérisée en ce que** le dispositif est agencé pour déterminer une chute de tension entre une borne de la résistance (6) et une masse.

4. Machine selon la revendication 2 **caractérisée en ce que** le dispositif est agencé pour déterminer une chute de tension aux deux bornes de la résistance (6).

5. Machine selon l'une quelconque des revendications 2 à 4 **caractérisée en ce que** le dispositif comprend un interrupteur (7).

6. Machine selon la revendication 1 **caractérisée en ce que** le dispositif comprend une sonde à effet Hall (26).

7. Procédé de commande du dispositif pour la mesure d'un courant d'une machine électrique tournante selon la revendication 5, **caractérisé en ce que** l'interrupteur (7) est commandé dans une première position durant un écart de temps (ΔT) pendant lequel on vient mesurer le courant et **en ce que** l'interrupteur (7) est commandé dans une deuxième position en dehors de l'écart de temps (ΔT).

8. Procédé de commande selon la revendication 7 **caractérisé en ce que** le courant est mesuré en sortie d'une phase (1, 2, 3) du stator.

9. Procédé de commande selon la revendication 8 **caractérisé en ce que** l'interrupteur (7) est commandé en fonction de la tension présente sur la phase en sortie de laquelle est mesuré le courant.

10. Procédé de commande selon la revendication 8 **caractérisé en ce que** le stator (10) comporte plusieurs phases (1, 2, 3) et **en ce que** l'interrupteur (7) est commandé dans sa première position en fonction de la tension présente sur au moins une phase autre que la phase en sortie de laquelle est mesuré le courant.

11. Procédé de commande selon la revendication 9 **caractérisé en ce qu'**il comporte les étapes suivantes :
- le régulateur mesure une tension (U1) présente sur une première phase (1),
- le régulateur mesure une période (P) de la tension présente sur la phase (1),
- le régulateur calcule un intervalle de temps (ΔP) proportionnel à la période (P),
- le régulateur détecte un premier temps (t1) où la tension présente sur la phase (1) est dans un front descendant,
- l'interrupteur (7) est amené dans sa première position, à partir d'un deuxième temps (t2) égal au premier temps (t1) additionné de l'intervalle de temps (ΔP),
- l'interrupteur (7) est amené dans sa deuxième position, à partir d'un troisième temps (t3) égal au deuxième temps (t2) additionné de l'écart de temps (ΔT).

12. Procédé de commande selon la revendication précédente **caractérisé en ce que** l'intervalle de temps (ΔP) est égal à la période (P) divisée par quatre.

13. Procédé de commande selon la revendication 10 **caractérisé en ce que** le stator (10) comporte trois phases (1, 2, 3) et **en ce que** l'on vient mesurer le courant (I1) en sortie de la première phase (1), le procédé comportant les étapes suivantes :
- le régulateur mesure la tension (U3) de la troisième phase (3),
- le régulateur détecte un premier temps (t1) où la tension de la troisième phase est dans un front montant,
- l'interrupteur (7) est amené dans sa première position à partir du premier temps (t1),
- l'interrupteur (7) est amené dans sa deuxième position à partir d'un deuxième temps (t2) égal au premier temps (t1) additionné de l'écart de temps (ΔT).

14. Procédé de commande selon la revendication 10 **caractérisé en ce que** le stator (10) comporte trois phases (1, 2, 3) et **en ce que** l'on vient mesurer le courant (I1) en sortie de la première phase (1), le procédé comportant les étapes suivantes :
- le régulateur mesure la tension (U2) de la deuxième phase (2),
- le régulateur mesure la tension (U3) de la troisième phase (3),
- le régulateur détecte un premier temps (t1) où la tension (U3) de la troisième phase est confondue avec la tension (U2) de la deuxième phase (2) sur son niveau haut,
- l'interrupteur (7) est amené dans sa première position à partir du premier temps (t1),
- l'interrupteur (7) est amené dans sa deuxième position à partir d'un deuxième temps (t2) égal au premier temps (t1) additionné de l'écart de temps (ΔT).

15. Procédé de commande selon la revendication précédente **caractérisé en ce que** le deuxième temps (t2) est détecté lorsque la tension (U2) de la deuxième phase n'est plus confondue avec la tension (U3) de la troisième phase (3).

16. Procédé de commande selon l'une quelconque des revendications 7 à 15 **caractérisé en ce que** l'écart de temps (ΔT) est inférieur à la période (P) divisée par deux d'une tension présente sur une phase.

## Claims

1. Rotary electrical machine, in particular an alternator or an alternator starter, capable of supplying electrical loads, comprising:
- a stator (10),
- a rotor (11),
- a current rectifier connected to the output of the stator,
- a device for measuring a current present in the rotary electrical machine supplying the electrical loads (14, 15),
**characterised in that** the stator (10) comprises one or more phases and **in that** the device is placed in a half-arm of the rectifier so as to measure a current (I1, I2, I3) at the output of a phase (1, 2, 3) flowing between the stator and the electrical loads (14, 15).

2. Machine according to the preceding claim, **characterised in that** the device comprises a resistor (6).

3. Machine according to the preceding claim, **characterised in that** the device is arranged to determine a voltage drop between one terminal of the resistor (6) and an earth.

4. Machine according to claim 2, **characterised in that** the device is arranged to determine a voltage drop at the two terminals of the resistor (6).

5. Machine according to any one of claims 2 to 4, **characterised in that** the device comprises a switch (7).

6. Machine according to claim 1, **characterised in that** the device comprises a Hall effect sensor (26).

7. Method of controlling the device for measuring a current of a rotary electrical machine according to claim 5, **characterised in that** the switch (7) is controlled in a first position during a time difference (ΔT) during which the current is measured and **in that** the switch (7) is controlled in a second position outside the time difference (ΔT).

8. Control method according to claim 7, **characterised in that** the current is measured at the output of a phase (1, 2, 3) of the stator.

9. Control method according to claim 8, **characterised in that** the switch (7) is controlled according to the voltage present on the phase at the output of which the current is measured.

10. Control method according to claim 8, **characterised in that** the stator (10) comprises several phases (1, 2, 3) and **in that** the switch (7) is controlled in its first position according to the voltage present on at least one phase other than the phase at the output of which the current is measured.

11. Control method according to claim 9, **characterised in that** it comprises the following steps:
- the regulator measures a voltage (U1) present on a first phase (1),
- the regulator measures a period (P) of the voltage present on the phase (1),
- the regulator calculates a time interval (ΔT) proportional to the period (P),
- the regulator detects a first time (t1) where the voltage present on the phase (1) is in a falling edge,
- the switch (7) is brought into its first position, as from a second time (t2) equal to the first time (t1) with the time interval (ΔP) added,
- the switch (7) is brought into its second position, as from a third time (t3) equal to the second time (t2) with the time difference (ΔT) added.

12. Control method according to the preceding claim, **characterised in that** the time interval (ΔP) is equal to the period (P) divided by four.

13. Control method according to claim 10, **characterised in that** the stator (10) comprises three phases (1, 2, 3) and **in that** the current (I1) is measured at the output of the first phase (1), the method comprising the following steps:
- the regulator measures the voltage (U3) of the third phase (3),
- the regulator detects a first time (t1) where the voltage of the third phase is in a rising edge,
- the switch (7) is brought into its first position as from the first time (t1),
- the switch (7) is brought into its second position as from a second time (t2) equal to the first time (t1) with the time difference (ΔT) added.

14. Control method according to claim 10, **characterised in that** the stator (10) comprises three phases (1, 2, 3) and **in that** the current (I1) is measured at the output of the first phase (1), the method comprising the following steps:
- the regulator measures the voltage (U2) of the second phase (2),
- the regulator measures the voltage (U3) of the third phase (3),
- the regulator detects a first time (t1) where the voltage (U3) of the third phase is merged with the voltage (U2) of the second phase (2) on its high level,
- the switch (7) is brought into its first position as from the first time (t1),
- the switch (7) is brought into its second position as from a second time (t2) equal to the first time (t1) with the time difference (ΔT) added.

15. Control method according to the preceding claim, **characterised in that** the second time (t2) is detected when the voltage (U2) of the second phase is no longer merged with the voltage (U3) of the third phase (3).

16. Control method according to any one of claims 7 to 15, **characterised in that** the time difference (ΔT) is less than the period (P) divided by two of a voltage present on a phase.

## Patentansprüche

1. Rotierende elektrische Maschine, insbesondere ein Wechselstromgenerator oder ein Anlassergenerator, der elektrische Verbraucher speisen kann, mit:
- einem Stator (10),
- einem Rotor (11),
- einem an den Ausgang des Stators angeschlossenen Gleichrichter,
- einer Vorrichtung zur Messung eines in der rotierenden elektrischen Maschine vorhandenen Stroms, der die elektrischen Verbraucher (14, 15) speist,
**dadurch gekennzeichnet, dass** der Stator (10) eine oder mehrere Phasen aufweist und dass die Vorrichtung in einem Halbstrang des Gleichrichters angebracht ist, um einen Strom (I1, I2, I3) am Ausgang einer Phase (1,2, 3) zu messen, der zwischen dem stator und den elektrischen Verbrauchern (14,15) fließt.

2. Maschine nach dem vorangehenden Anspruch, **dadurch gekennzeichnet, dass** die Vorrichtung einen Widerstand (6) umfasst.

3. Maschine nach dem vorangehenden Anspruch, **dadurch gekennzeichnet, dass** die Vorrichtung angeordnet ist, um einen Spannungsabfall zwischen einer Klemme des Widerstands (6) und einer Masse zu bestimmen.

4. Maschine nach Anspruch 2, **dadurch gekennzeichnet, dass** die Vorrichtung angeordnet ist, um einen Spannungsabfall an den beiden Klemmen des Widerstands (6) zu bestimmen.

5. Maschine nach einem der Ansprüche 2 bis 4, **dadurch gekennzeichnet, dass** die Vorrichtung einen Schalter (7) umfässt.

6. Maschine nach Anspruch 1, **dadurch gekennzeichnet, dass** die Vorrichtung einen Hall-Sensor (26) umfasst.

7. Verfahren zur Steuerung der Vorrichtung zur Messung eines Stroms einer rotierenden elektrischen Maschine nach Anspruch 5, **dadurch gekennzeichnet, dass** der Schalter (7) während eines Zeitabstands (Δt), in dessen Verlauf der Strom gemessen wird, in einer ersten Position angesteuert wird und dass der Schalter (7) außerhalb des Zeitabstands (Δt) in einer zweiten Position angesteuert wird.

8. Steuerungsverfahren nach Anspruch 7, **dadurch gekennzeichnet, dass** der Strom am Ausgang einer Phase, (1, 2, 3) des Stators gemessen wird.

9. Steuerungsverfahren nach Anspruch 8, **dadurch gekennzeichnet, dass** der Schalter (7) in Abhängigkeit von der Spannung angesteuert wird, die an der Phase anliegt, an deren Ausgang der Strom gemessen wird.

10. Steuerungsverfahren nach Anspruch 8, **dadurch gekennzeichnet, dass** der stator (10) mehrere Phasen (1, 2, 3) umfasst und dass der Schalter (7) in Abhängigkeit von der Spannung die an mindestens einer anderen Phase als der Phase anliegt, an deren. Ausgang der Strom gemessen wird, in seiner ersten Position angesteuert wird.

11. Steuerungsverfahren nach Anspruch 9, **dadurch gekennzeichnet, dass** es die folgenden Verfahrensschritte umfasst;
- der Regler misst eine Spannung (U1), die an einer ersten Phase (1) anliegt,
- der Regler misst eine Periode (P) der Spannung, die an der Phase (1) anliegt,
- der Regler berechnet ein zur Periode (P) proportionales Zeitintervall (ΔP),
- der Regler erfasst eine erste Zeit (t1), in der sich die an der Phase (1) anliegende Spannung in einer fallenden Flanke befindet,
- nach einer zweiten Zeit (t2) gleich der ersten Zeit (t1) plus dem Zeitintervall (ΔP) wird der Schalter (7) in seine erste Position verbracht,
- nach einer dritten Zeit (t3) gleich der zweiten Zeit (t2) plus dem Zeitabstand (ΔT) wird der Schalter (7) in seine zweite Position verbracht.

12. Steuerungsverfahren nach dem vorangehenden Anspruch, **dadurch gekennzeichnet, dass** das Zeitintervall (ΔP) gleich der Periode (P), dividiert durch vier, ist.

13. Steuerungsverfahren nach Anspruch 10, **dadurch gekennzeichnet, dass** der Stator (10) drei Phasen (1, 2, 3) umfasst und dass der Strom (I1) am Ausgang der ersten Phase (1) gemessen wird, wobei das Verfahren die folgenden Verfahrensschritte umfasst :
- der Regler misst die Spannung (U3) der dritten Phase (3),
- der Regler erfasst eine erste Zeit (t1), in der sich die Spannung der dritten Phase in einer steigenden Flanke befindet.
- nach der ersten Zeit (t1) wird der Schalter (7) in seine erste Position verbracht,
- nach einer zweiten Zeit (t2) gleich der ersten Zeit. (t1) plus dem Zeitabstand (ΔT) wird der Schalter (7) in seine zweite Position verbracht.

14. Steuerungsverfahren nach Anspruch 10, **dadurch gekennzeich net, dass** der Stator (10) drei Phasen (1, 2, 3) umfasst und dass der Strom (I1) am Ausgang der ersten Phase (1) gemessen wird, wobei das Verfahren die folgenden Verfahrensschritte umfasst:
- der Regler misst die Spannung (U2) der zweiten Phase (2),
- der Regler misst die Spannung (U3) der dritten Phase (3),
- der Regler erfasst eine erste Zeit (t1), in der die Spannung (U3) der dritten Phase mit der Spannung (U2) der Zweiten Phase (2) auf ihrem hohen Pegel zusammenfällt,
- nach der ersten Zeit (t1) wird der Schalter (7) in seine erste Position verbracht,
- nach einer zweiten Zeit (t2) gleich der ersten Zeit (t1) plus dem Zeitabstand (ΔT) wird der Schalter (7) in seine zweite Position verbracht

15. Steuerungsverfahren nach dem vorangehenden Anspruch, **dadurch gekennzeichnet, dass** die zweite Zeit (t2) erfasst wird, wenn die Spannung (U2) der zweiten Phase nicht mehr mit der Spannung (U3) der dritten Phase (3) zusammenfällt.

16. Steuerungsverfahren nach einem der Ansprüche 7 bis 15, **dadurch gekennzeichnet, dass** der Zeitabstand (Δt) kleiner als die durch zwei dividierte Periode einer an einer Phase anliegenden Spannung ist.
